# EUROPÄISCHE PATENTSCHRIFT

(11) **EP 2 721 635 B1**
(45) Veröffentlichungstag und Bekanntmachung des Hinweises auf die Patenterteilung: **29.07.2015**
(21) Anmeldenummer: 12727597.2
(22) Anmeldetag: 12.06.2012
(51) Int. Cl.: H05K 13/02, H01L 21/67, H01L 21/68

(54) **VORRICHTUNG UND VERFAHREN ZUM POSITIONIEREN EINES ELEKTRONISCHEN BAUTEILS UND/ODER EINES TRÄGERS RELATIV ZU EINER AUSSTOSSEINRICHTUNG**
APPARATUS AND METHOD FOR POSITIONING AN ELECTRONIC COMPONENT AND/OR A CARRIER RELATIVE TO A DISCHARGING DEVICE
DISPOSITIF ET PROCÉDÉ DE POSITIONNEMENT D'UN COMPOSANT ÉLECTRONIQUE ET/OU D'UN SUPPORT PAR RAPPORT À UN DISPOSITIF D'ÉJECTION

(30) Priorität: 15.06.2011 DE 102011104225
(43) Veröffentlichungstag der Anmeldung: 23.04.2014
(73) Patentinhaber: Mühlbauer GmbH & Co. KG, 93426 Roding (DE)
(72) Erfinder: PRAKAPENKA, Uladimir, 93426 Roding (DE); MIEHLICH, Rainer, 82024 Taufkirchen (DE)
(74) Vertreter: Schmidt, Steffen J.
(86) Internationale Anmeldenummer: PCT/EP2012/002482
(87) Internationale Veröffentlichungsnummer: WO 2012/171633

(56) Entgegenhaltungen:
- EP-A1- 1 764 826
- WO-A1-03/098990
- DE-A1- 19 536 005
- JP-A- 5 029 439
- US-A- 5 262 355
- US-A1- 2011 061 227
- US-B1- 6 589 809

## Beschreibung

### Hintergrund

Es wird eine Vorrichtung und ein Verfahren zum Positionieren eines elektronischen Bauteils und / oder eines Trägers relativ zu einer Ausstoßeinrichtung beschrieben. Insbesondere wird eine Vorrichtung und ein Verfahren beschrieben, bei der ein elektronisches Bauteil und / oder ein Träger vor dem Übertragen des elektronischen Bauteils auf den Träger positioniert wird.

Beim Übertragen von elektronischen Bauteilen, insbesondere Chips (engl.: "dies") und insbesondere beim Übertragen von vereinzelten elektronischen Bauteilen besteht allgemein das Problem, dass die elektronischen Bauteile einer kontinuierlichen Miniaturisierung unterworfen sind, so dass die Anforderungen hinsichtlich der Genauigkeit beim Übertragen der elektronischen Bauteile kontinuierlich steigen.

So wird zum Beispiel in DE 10 2006 027 663 A1 ein optisches Inspektionssystem zur Vermessung von elektronischen Bauelementen beschrieben, das eine Inspektion von ungehäusten Bauelementen ermöglicht, bevor diese von einem Bestückkopf aufgenommen werden. In JP 2009 016455 A wird eine Vorrichtung und ein Verfahren zum Erfassen der Position eines Substrates beschrieben. Ein Beispiel einer Vorrichtung zum Übertragen elektronischer Bauteile von einem ersten Träger zu einem zweiten Träger wird in der DE 10 2011 017 218 A1 beschrieben.

In DE 103 49 847 B3 wird zum Beispiel eine Positioniervorrichtung und ein Positionierverfahren für die Übertragung elektronischer Bauteile beschrieben. Dabei ist ein auf einer Trägerfolie angeordneter Halbleiter-Wafer oberhalb und parallel zu einem bandartigen Substrat angeordnet. Der Wafer kann mittels einer Waferhalterung innerhalb der Waferebene verschoben und zusätzlich um eine senkrecht zu der Waferebene stehende Rotationsachse gedreht werden. Eine Ausstoßeinrichtung umfasst eine Ausstechnadel, die mittels einer Bewegung nach unten auf die Rückseite eines abzulösenden Chips wirkt und diesen von der Trägerfolie ablöst. Der von der Trägerfolie abgelöste Chip wird dadurch auf eine Bondposition auf dem bandartigen Substrat abgelegt.

Dabei besteht aber das Problem, dass die elektronischen Bauteile und die Bondposition von oben durch die Ausstoßeinrichtung und die Trägerfolie sowie von unten durch das Substrat verdeckt sind. Zudem ist der Spalt zwischen der Trägerfolie und dem Substrat meist sehr schmal, so dass die Position der elektronischen Bauteile und der Bondposition optisch nicht erfasst werden kann. Entsprechend ist es nicht möglich, ein einzelnes Bauteil und / oder das Substrat vor dem Übertragen des Bauteils exakt zueinander auszurichten, also zueinander zu positionieren. Stattdessen wird bisher die Position der elektronischen Bauteile vor dem Übertragen, außerhalb der Vorrichtung, erfasst und es wird davon ausgegangen, dass sich die Position der Bauteile nicht mehr verändert. Falls die Position eines Bauteils durch das Übertragen eines anderen Bauteils verändert wird, kann dies dazu führen, dass eine Vielzahl der elektronischen Bauteile ungenau auf das Substrat übertragen wird.

Da ein ungenau platziertes elektronisches Bauteil in der Regel als Schlechtteil und somit als Ausschuss anzusehen ist, ist ein möglichst genaues Platzieren des Bauteils wünschenswert.

Dabei führt sowohl ein ungenau übertragenes Bauteil als auch ein ungenau bereitgestelltes Substrat zu einem fehlerhaft platzierten Bauteil.

### Problem

Somit besteht die Aufgabe, eine Vorrichtung und ein Verfahren bereitzustellen, mit der die Position des elektronischen Bauteils und / oder des Substrats vor dem Übertragen des elektronischen Bauteils exakt erfasst und gegebenenfalls korrigiert werden kann. Zudem soll die Durchsatzrate nicht beeinträchtigt werden.

### Vorgeschlagene Lösung

Zur Lösung dieser Aufgabe wird eine Vorrichtung zum Positionieren zu übertragender elektronischer Bauteile relativ zu einer Ausstoßeinrichtung vorgeschlagen. Dabei weist die Ausstoßeinrichtung einen Schieber für zumindest ein elektronisches Bauteil und ein den Schieber umgebendes Gehäuse auf, wobei das Gehäuse einen ersten lichtdurchlässigen Bereich aufweist. Ein die zu übertragenden elektronischen Bauteile bereitstellender erster Träger umfasst eine der Ausstoßeinrichtung zugewandte erste Seite und eine von der Ausstoßeinrichtung abgewandte zweite Seite, wobei auf der zweiten Seite eine Vielzahl der elektronischen Bauteile vorgesehen ist. Zumindest eine Bilddatenerfassungseinrichtung ist dazu eingerichtet, durch den ersten lichtdurchlässigen Bereich des Gehäuses hindurch Bilddaten einer Region zu erfassen, in der der Schieber mit dem wenigstens einen elektronischen Bauteil zu interagieren eingerichtet ist. Eine Steuerung ist dazu eingerichtet, aus den erfassten Bilddaten Positionsdaten des zu übertragenden elektronischen Bauteils zu ermitteln und aufgrund der Positionsdaten Steuerbefehle zu erzeugen. Zumindest ein erster Aktor ist dazu eingerichtet, den ersten Träger und die Ausstoßeinrichtung aufgrund der Steuerbefehle relativ zueinander zu bewegen, um einen Versatz zwischen einer Längsachse des Schiebers und einer Mittelachse des zu übertragenden elektronischen Bauteils zu verändern.

Aufgrund des lichtdurchlässigen Bereichs kann die Bilddatenerfassungseinrichtung Bilddaten durch die Ausstoßeinrichtung hindurch erfassen und entsprechend auch die Position der elektronischen Bauteile erfassen die bisher durch die Ausstoßeinrichtung verdeckt wurden. Daher kann die Position der elektronischen Bauteile sehr genau erfasst werden und somit die elektronischen Bauteile präziser positioniert werden. Da zudem das Positionieren der elektronischen Bauteile in der Anordnung der Ausstoßeinrichtung, des ersten Trägers und des zweiten Trägers erfolgen kann, in der die elektronischen Bauteile übertragen werden, wird die Durchsatzrate nicht durch zusätzlich Verfahrwege beeinträchtig.

Außerdem kann durch den lichtdurchlässigen Bereich das Gehäuse zumindest teilweise abgedichtet werden, so dass ein Unterdruck innerhalb des Gehäuses leichter aufrechterhalten werden kann.

Zur Lösung der gestellten Aufgabe wird zudem ein Verfahren zum Positionieren eines zu übertragenden elektronischen Bauteils relativ zu einer Ausstoßeinrichtung vorgeschlagen. Dabei wird ein erster Träger mit elektronischen Bauteilen derart bereitgestellt, dass eine erste Seite des ersten Trägers an der Ausstoßeinrichtung anliegt. An einer von der Ausstoßeinrichtung abgewandten zweiten Seite des ersten Trägers ist dabei eine Vielzahl von elektronischen Bauteilen vorgesehen. Bilddaten werden mittels einem durch einen ersten Spiegel abgelenkten Strahlengangs erfasst, wobei die Bilddaten Informationen zur Position eines Schiebers der Ausstoßeinrichtung und zur Position eines zu übertragenden elektronischen Bauteils umfassen. Positionsdaten des zu übertragenden elektronischen Bauteils werden aufgrund der erfassten Bilddaten ermittelt. Steuerbefehle zum Ansteuern zumindest eines ersten Aktors werden aufgrund der ermittelten Positionsdaten des zu übertragenden elektronischen Bauteils erzeugt; und der erste Träger und / oder die Ausstoßeinrichtung werden aufgrund des erzeugten Steuerbefehls relativ zueinander bewegt, um einen Versatz zwischen einer Längsachse des Schiebers und einer Mittelachse des zu übertragenden elektronischen Bauteils zu verändern.

Aufgrund des lichtdurchlässigen Bereichs kann die Bilddatenerfassungseinrichtung Bilddaten durch die Ausstoßeinrichtung hindurch erfassen und entsprechend auch die Position der elektronischen Bauteile erfassen die bisher durch die Ausstoßeinrichtung verdeckt wurden. Daher kann die Position der elektronischen Bauteile sehr genau erfasst werden und somit die elektronischen Bauteile präziser positioniert werden. Da zudem das Positionieren der elektronischen Bauteile in der Anordnung der Ausstoßeinrichtung, des ersten Trägers und des zweiten Trägers erfolgen kann, in der die elektronischen Bauteile übertragen werden, wird die Durchsatzrate nicht durch zusätzlich Verfahrwege beeinträchtig.

Außerdem kann durch den lichtdurchlässigen Bereich das Gehäuse zumindest teilweise abgedichtet werden, so dass ein Unterdruck innerhalb des Gehäuses leichter aufrechterhalten werden kann.

Zur Lösung der gestellten Aufgabe wird zudem ein Verfahren zum Positionieren eines zu übertragenden elektronischen Bauteils relativ zu einer Ausstoßeinrichtung vorgeschlagen. Dabei wird ein erster Träger mit elektronischen Bauteilen derart bereitgestellt, dass eine erste Seite des ersten Trägers an der Ausstoßeinrichtung anliegt. An einer von der Ausstoßeinrichtung abgewandten zweiten Seite des ersten Trägers ist dabei eine Vielzahl von elektronischen Bauteilen vorgesehen. Bilddaten werden erfasst, wobei die Bilddaten Informationen zur Position eines Schiebers der Ausstoßeinrichtung und zur Position eines zu übertragenden elektronischen Bauteils umfassen. Positionsdaten des zu übertragenden elektronischen Bauteils werden aufgrund der erfassten Bilddaten ermittelt. Steuerbefehle zum Ansteuern zumindest eines ersten Aktors werden aufgrund der ermittelten Positionsdaten des zu übertragenden elektronischen Bauteils erzeugt; und der erste Träger und / oder die Ausstoßeinrichtung werden aufgrund des erzeugten Steuerbefehls relativ zueinander bewegt, um einen Versatz zwischen einer Längsachse des Schiebers und einer Mittelachse des zu übertragenden elektronischen Bauteils zu verändern.

Ebenso wird eine Vorrichtung zum Positionieren eines zweiten Trägers mit zumindest einer Kontaktfläche zur Aufnahme eines elektronischen Bauteils relativ zu einer Ausstoßeinrichtung vorgeschlagen. Diese Vorrichtung umfasst eine lichtdurchlässige Auflage, auf der eine erste Seite des zweiten Trägers aufliegt; zumindest eine dritte Strahlenquelle, die beabstandet von dem zweiten Träger auf einer von der lichtdurchlässigen Auflage abgewandten zweiten Seite des zweiten Trägers angeordnet ist; zumindest ein optisches Sensorelement, das dazu eingerichtet ist, eine auf den zweiten Träger aufgebrachte Markierung zu erfassen und entsprechende Sensorsignale zu erzeugen; und eine Steuerung, die dazu eingerichtet ist, aus den Sensorsignalen Positionsdaten der Kontaktfläche zu ermitteln und aufgrund der Positionsdaten Steuerbefehle zu erzeugen; und zumindest einen zweiten Aktor, der dazu eingerichtet ist, einen ersten Träger, den zweiten Träger und / oder eine Ausstoßeinrichtung aufgrund der Steuerbefehle zu bewegen, um einen Versatz zwischen einer Längsachse der Ausstoßeinrichtung und der Kontaktfläche zu verändern.

Durch das beabstandete Anordnen der dritten Strahlenquelle auf der zweiten Seite des zweiten Trägers kann ein Abbild des zweiten Trägers zu dem optischen Sensorelement projiziert werden. Durch die Projektion können auch geringe Unterschiede in der Opazität der auf den zweiten Träger vorgesehenen Strukturen und des Materials des zweiten Trägers als Helligkeitsunterschiede erfasst werden. Daher können auch Trägermaterialien verwendet werden, die eine relativ große Opazität aufweisen, wie zum Beispiel Papier oder einige Kunststoffe.

Ferner wird ein Verfahren zum Positionieren eines zweiten Trägers relativ zu einer Ausstoßeinrichtung vorgeschlagen. Dabei wird der zweite Träger, der zumindest eine Kontaktfläche zur Aufnahme eines zu übertragenden elektronischen Bauteils aufweist, derart bereitgestellt, dass ein optisches Sensorelement eine auf dem zweiten Träger vorgesehene Markierung erfassen kann. Ein Abbild des zweiten Trägers wird zum optischen Sensorelement projiziert. Sensorsignale werden erzeugt, wobei die Sensorsignale Informationen zur Position der Markierung und der Position der Ausstoßeinrichtung umfassen. Aus den erzeugten Sensorsignalen werden Positionsdaten der Kontaktfläche ermittelt. Aus den ermittelten Positionsdaten werden Steuerbefehle zum Ansteuern zumindest eines zweiten Aktors erzeugt; und der zweite Träger, der erste Träger und / oder die Ausstoßeinrichtung werden aufgrund der erzeugten Steuerbefehle bewegt, um einen Versatz zwischen der Kontaktfläche und einer Längsachse eines Schiebers der Ausstoßeinrichtung zu verändern.

Schließlich wird eine Vorrichtung und ein Verfahren zum Übertragen eines elektronischen Bauteils von einem ersten Träger zu einem zweiten Träger vorgeschlagen. Die Vorrichtung beziehungsweise das Verfahren umfasst dabei die Vorrichtung / das Verfahren zum Positionieren eines zu übertragenden elektronischen Bauteils relativ zu einer Ausstoßeinrichtung und / oder die Vorrichtung / das Verfahren zum Positionieren eines zweiten Trägers relativ zu einer Ausstoßeinrichtung.

Da die auf den ersten Träger bereitgestellten elektronischen Bauteile sowie der zweite Träger exakt zueinander ausgerichtet werden, können die elektronischen Bauteile mit einer höheren Genauigkeit als bisher übertragen werden. Dies ermöglicht es, auch sehr kleine Bauteile zu übertragen.

### Ausgestaltung und Eigenschaften der Vorrichtung und des Verfahrens

In den von der Bilddatenerfassungseinrichtung erfassten Bilddaten kann die Position der elektronischen Bauteile zum Beispiel aufgrund von Sägestraßen die zwischen den einzelnen elektronischen Bauteilen vorgesehen sind erfasst werden.

Die von der Bilddatenerfassungseinrichtung erfasste Region kann ein zu übertragendes elektronisches Bauteil, also das Bauteil das als nächstes übertragen werden soll, sowie benachbarte Bauteile umfassen. Dabei ist es auch möglich, dass das zu übertragende elektronische Bauteil durch den Schieber verdeckt ist. In diesem Fall kann die Position des zu übertragenden Bauteils zum Beispiel aus der Position der umliegenden / unmittelbar benachbarten Bauteile und / oder aus den Verlauf der Sägestraßen ermittelt werden.

Je nach Ausgestaltung der Vorrichtung kann das Positionieren der zu übertragenden elektronischen Bauteile und / oder des zweiten Trägers durch eine Bewegung der Ausstoßeinrichtung, des ersten Trägers und / oder des zweiten Trägers erfolgen. Entsprechend bezeichnet der Begriff "Positionieren" insbesondere eine Relativbewegung zwischen der Ausstoßeinrichtung und dem ersten Träger sowie eine Relativbewegung zwischen der Ausstoßeinrichtung, dem ersten Träger und dem zweiten Träger. Ob für diese Relativbewegung der zumindest eine erste Aktor und / oder der zumindest eine zweite Aktor die Ausstoßeinrichtung, den ersten Träger und / oder den zweiten Träger bewegt ist nicht relevant.

Innerhalb des Gehäuses kann eine erste Strahlenquelle vorgesehen sein. Die erste Strahlenquelle kann zum Beispiel zumindest eine LED oder zumindest eine Laserdiode sein. Die von der ersten Strahlenquelle abgegebene Wellenlänge kann dabei im sichtbaren Bereich, im Ultravioletten-Bereich und / oder im Infrarot-Bereich liegen.

Die erste Strahlenquelle kann auch außerhalb des Gehäuses vorgesehen sein. Dabei kann die erste Strahlenquelle die von der Bilddatenerfassungseinrichten erfasste Region durch den ersten lichtdurchlässigen Bereich hindurch beleuchten. Zusätzlich oder alternativ kann auch ein dritter lichtdurchlässiger Bereich vorgesehen sein, durch den die erste Strahlenquelle die von der Bilddatenerfassungseinrichtung erfasste Region beleuchten kann.

Im Inneren des Gehäuses der Ausstoßeinrichtung kann ein erster Spiegel angeordnet sein. Ungefähr in der Mitte des ersten Spiegels kann eine Öffnung vorgesehen sein. Durch diese Öffnung kann der Schieber, in Richtung seiner Längsachse, beweglich angeordnet sein. Sofern der erste Spiegel vorgesehen ist, kann in einem besonders einfachen Ausführungsbeispiel auf den ersten lichtdurchlässigen Bereich verzichtet werden. Bei einem derartigen Ausführungsbeispiel kann in dem Gehäuse lediglich eine Aussparung oder ein Sichtkanal vorgesehen sein, so dass das Innere des Gehäuses nicht durch einen lichtdurchlässigen Bereich begrenzt wird.

Außerdem kann außerhalb des Gehäuses ein zweiter Spiegel vorgesehen sein. Der zweite Spiegel kann ein halbdurchlässiger Spiegel sein, der dazu eingerichtet ist, elektromagnetische Strahlung einer zweiten Strahlenquelle einzukoppeln. Die zweite Strahlenquelle kann zum Beispiel der ersten Strahlenquelle entsprechen. Die zweite Strahlenquelle kann zudem elektromagnetische Strahlung abgeben, durch die das elektronische Bauteil zumindest teilweise von dem ersten Träger gelöst wird.

Das Gehäuse kann einen zweiten lichtdurchlässigen Bereich aufweisen. In dem zweiten lichtdurchlässigen Bereich kann eine Öffnung vorgesehen sein, durch die der Schieber, in Richtung seiner Längsachse, beweglich angeordnet ist.

Zwischen dem zumindest einem optischen Sensorelement und der lichtdurchlässigen Auflage kann ein Spiegelelement angeordnet sein, das dazu eingerichtet ist, von einer vierten Strahlenquelle abgegebene elektromagnetische Strahlung in den Strahlengang zwischen dem optischen Sensorelement und der lichtdurchlässigen Auflage einzukoppeln. Das Spiegelelement kann zum Beispiel ein teildurchlässiger oder halbdurchlässiger Spiegel sein.

Die Kontaktfläche für das zu übertragende elektronische Bauteil und / oder eine auf dem zweiten Träger vorgesehene Leiterstruktur kann als Markierung verwendet werden.

Die dritte Strahlenquelle kann dazu eingerichtet sein, die zweite Seite des ersten Trägers und die zweite Seite des zweiten Trägers zu beleuchten. Entsprechend kann mit der dritten Strahlenquelle ein Abbild des ersten Trägers zur Bilddatenerfassungseinrichtung und ein Abbild des zweiten Trägers zum optischen Sensorelement projiziert werden.

Bevor die Positionsdaten aus den Bilddaten ermittelt werden, können die Bilddaten bearbeitet werden, um eine perspektivische Verzerrung in den Bilddaten zu verändern. Dies kann zum Beispiel dann vorteilhaft sein, wenn die Bilddatenerfassungseinrichtung seitlich angeordnet ist und daher die Bilddaten schräg erfasst.

### Kurzbeschreibung der Zeichnungen

Weitere Ziele, Merkmale, Vorteile und Anwendungsmöglichkeiten der hier offenbarten Vorrichtung und des hier offenbarten Verfahrens ergeben sich aus der nachfolgenden Beschreibung von nicht einschränkend zu verstehenden Ausführungsbeispielen und den zugehörigen Zeichnungen.
Fig.1 zeigt ein erstes Ausführungsbeispiel einer Positioniervorrichtung für den ersten Träger;
Fig. 2 zeigt ein zweites Ausführungsbeispiel einer Positioniervorrichtung für den ersten Träger;
Fig. 3 zeigt das erste Ausführungsbeispiel einer Positioniervorrichtung für den ersten Träger sowie eine Positioniereinrichtung für den zweiten Träger;
Fig. 4 zeigt ein Flussdiagramm eines Verfahrens zum Positionieren eines ersten Trägers;
Fig. 5 zeigt ein Flussdiagramm eines Verfahrens zum Positionieren eines zweiten Trägers;
Fig. 6a und 6b zeigen ein drittes Ausführungsbeispiel einer Positioniervorrichtung für den ersten Träger;
Fig. 7 zeigt ein viertes Ausführungsbeispiel einer Positioniervorrichtung für den ersten Träger.

### Detaillierte Beschreibung von Ausführungsbeispielen

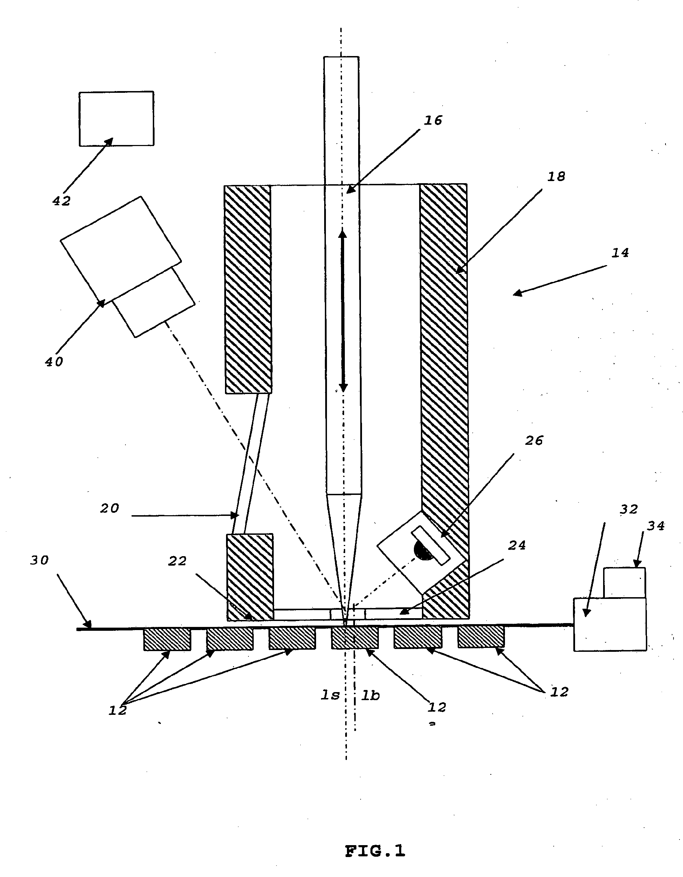

Die Fig. 1 zeigt ein Ausführungsbeispiel einer Vorrichtung zum Positionieren zu übertragender elektronischer Bauteile 12 relativ zu einer Ausstoßeinrichtung 14.

Die Ausstoßeinrichtung 14 weist einen Schieber 16 auf. Ein Ende des Schiebers 16 ist mit einem nicht dargestellten Aktor verbunden und ein anderes Ende des Schiebers 16 weist eine Spitze auf. Der Aktor des Schiebers 16 kann dabei so angesteuert werden, dass der Schieber 16 entlang der in Fig. 1 dargestellten Längsachse ls des Schiebers bewegt werden kann, so wie dies durch den Doppelpfeil in Fig. 1 angedeutet ist. Der Schieber 16 kann zum Beispiel eine Ausstoßnadel sein.

Der Schieber 16 ist von einem Gehäuse 18 umgeben. Das Gehäuse 18 hat eine langgestreckte Form und kann durch einen Aktor (nicht dargestellt) bewegt werden. Das Gehäuse 18 weist einen ersten lichtdurchlässigen Bereich 20 auf, der an einer Längsseite des Gehäuses 18 angeordnet ist. Lichtdurchlässig bedeutet dabei, dass der Bereich für einen Wellenlängenbereich elektromagnetischer Strahlung durchlässig ist. Dieser Wellenlängenbereich kann zum Beispiel im Ultravioletten (UV) Bereich, im Bereich der für den Menschen sichtbaren Strahlung und / oder im Infrarot (IR) Bereich liegen. Der erste lichtdurchlässige Bereich 20 kann zum Beispiel aus Glas oder Kunststoff gebildet sein und kann die Form einer Platte aufweisen. Zumindest eine Oberfläche des ersten lichtdurchlässigen Bereichs 20 kann dabei zu einer Längsachse des Gehäuses 18 gekippt sein, also mit der Längsachse des Gehäuses 18 eine Winkel einschließen der ungleich 0° ist. Dadurch können zum Beispiel Reflexionen auf der Oberfläche des lichtdurchlässigen Bereichs 20 vermindert werden.

An einer Seite des Gehäuses 18 ist eine Auflage 22 vorgesehen, an der ein erster Träger 30 anliegen kann. Die Auflage 22 ist dabei im Wesentlichen senkrecht zu der Längsachse Is des Schiebers angeordnet. Ungefähr in der Mitte der Auflage 22 ist ein zweiter lichtdurchlässiger Bereich 24 vorgesehen. Dieser zweite lichtdurchlässige Bereich 24 kann die Form einer Platte haben und kann aus dem gleichen Material wie der erste lichtdurchlässige Bereich 20 geformt sein. Entsprechend kann der zweite lichtdurchlässige Bereich 24 für den gleichen Wellenlängenbereich wie der erste lichtdurchlässige Bereich 20 transparent sein.

Beispielsweise kann der zweite lichtdurchlässige Bereich 24 einen Durchmesser von ungefähr 3 mm und eine Dicke von ungefähr 0,3 mm aufweisen. In dem zweiten lichtdurchlässigen Bereich 24 ist eine Öffnung vorgesehen, durch die der Schieber 16 bewegt werden kann. Der Durchmesser der Öffnung ist daher größer als der Durchmesser des Schiebers 16. So kann die Öffnung zum Beispiel einen Durchmesser von ungefähr 0,3 mm aufweisen.

An dem Gehäuse 18 ist eine erste Strahlenquelle 26 vorgesehen. Diese erste Strahlenquelle 26 kann innerhalb des Gehäuses 16 angeordnet sein, so wie dies in Fig. 1 beispielhaft dargestellt ist, oder außen an dem Gehäuse 18 angeordnet sein. Alternativ dazu kann die erste Strahlenquelle 26 auch an einem separaten Tragelement (nicht dargestellt) angebracht sein. Dadurch kann die Ausstoßeinrichtung 14 unabhängig von der erste Strahlenquelle 26 bewegt werden. Sofern die erste Strahlenquelle 26 außerhalb des Gehäuses 18 vorgesehen ist, kann die erste Strahlenquelle 26 durch den ersten lichtdurchlässigen Bereich 20 oder durch einen separaten dritten lichtdurchlässigen Bereich hindurch eine Region um die Spitze des Schiebers 16 beleuchten. Die erste Strahlenquelle 26 kann dabei Strahlung eines Wellenlängenbereichs abgeben, der in etwa dem Wellenlängenbereich entspricht, in dem die lichtdurchlässigen Bereiche 20, 24 transparent sind.

Zudem kann die erste Strahlenquelle 26 Strahlen eines Wellenlängenbereichs abgeben, der einen Wellenlängenbereich entspricht, in dem das Material des ersten Trägers 30 transparent ist oder eine geringe Opazität aufweist.

Da die lichtdurchlässigen Bereiche 20, 24 Öffnungen des Gehäuses 18 verschließen, kann das Gehäuse 18 im Wesentlichen luftdicht sein, so dass innerhalb des Gehäuses 18 ein Unterdruck aufgebaut werden kann. Dies kann zum Beispiel für das Übertragen der elektronischen Bauteile und / oder das Lösen der elektronischen Bauteile von dem ersten Träger 30 wünschenswert sein.

An der Auflage 22 liegt eine erste Seite des ersten Trägers 30 an. Der erste Träger 30 hat eine zweite, von der Auflage abgewandte Seite, auf der eine Vielzahl der elektronischen Bauteile 12 vorgesehen ist. Der erste Träger 30 kann zum Beispiel eine Waferfolie sein. Die elektronischen Bauteile können vereinzelte Dies sein, die vor dem Vereinzeln auf die Waferfolie aufgebracht wurden. Der erste Träger 30 wird durch eine Aufnahme 32 gehalten. An der Aufnahme 32 ist zumindest ein erster Aktor 34 vorgesehen, der ein Positionieren der an den ersten Träger 30 angebrachten elektronischen Bauteile 12 ermöglicht. Insbesondere kann der erste Aktor 34 dazu eingerichtet sein, die Auflage und den ersten Träger 30 parallel zur Auflage 22, also in Richtungen die senkrecht zu der Längsachse ls des Schiebers 16 sind, zu bewegen.

Außerdem ist in Fig. 1 eine Bilddatenerfassungseinrichtung 40 dargestellt. Die Bilddatenerfassungseinrichtung 40 ist seitlich neben dem Gehäuse 18 angeordnet. Die Bilddatenerfassungseinrichtung 40 kann zum Beispiel an einem nicht dargestellten Tragelement angebracht sein, so dass die Ausstoßeinrichtung 14 unabhängig von der Bilddatenerfassungseinrichtung 40 bewegt werden kann. Alternativ dazu kann die Bilddatenerfassungseinrichtung 40 auch an dem Gehäuse 18 angebracht sein, so dass die Bilddatenerfassungseinrichtung 40 mit der Ausstoßeinrichtung 14 bewegt werden kann.

Die Bilddatenerfassungseinrichtung 40 ist dabei derart zum ersten lichtdurchlässigen Bereich 20 angeordnet, dass die Bilddatenerfassungseinrichtung 40 Bilddaten einer Region um die Spitze des Schiebers 16 erfassen kann. Diese Region umfasst auch den Teil des ersten Trägers 30, der sich unter dem zweiten lichtdurchlässigen Bereich 24 befindet. Die Bilddatenerfassungseinrichtung 40 kann einen optischen Sensor und ein Objektiv umfassen. Ebenso kann eine Kamera als Bilddatenerfassungseinrichtung verwendet werden.

Die Bilddatenerfassungseinrichtung 40 kann elektromagnetische Strahlen eines bestimmten Wellenlängenbereichs in Signale umwandeln. Dieser Wellenlängenbereich kann dabei so gewählt sein, dass er zumindest teilweise den Wellenlängenbereichen entspricht in den die erste Strahlenquelle 26 Strahlen abgibt und in den die lichtdurchlässigen Bereiche 20, 24 transparent sind.

Die Bilddatenerfassungseinrichtung 40 ist zum Beispiel per Kabel oder Funk mit einer Steuerung 42, zum Beispiel einer speicherprogrammierbaren Steuerung, verbunden. Zudem ist die Steuerung 42 auch mit dem ersten Aktor 34 verbunden. Die Steuerung 42 ist dabei dazu eingerichtet, in den von der Bilddatenerfassungseinrichtung 40 erfassten Bilddaten Positionsdaten eines zu übertragenden elektronischen Bauteils 12 zu ermitteln. Anhand der Positionsdaten des zu übertragenden elektronischen Bauteils 12 kann die Steuerung 42 den Versatz zwischen der Längsachse ls des Schiebers 16 und einer durch den Schwerpunkt des elektronischen Bauteils 12 verlaufenden Mittelachse lb des elektronischen Bauteils ermitteln. Übersteigt der ermittelte Versatz einen Schwellenwert, kann die Steuerung 42 Steuerbefehle zum Ansteuern des ersten Aktors 34 erzeugen, um durch ein Bewegen des ersten Trägers 30 den Versatz zu verändern. Der erkannte Versatz kann auch durch ein Bewegen der Ausstoßeinrichtung 14 verändert werden. Je nach Ausgestaltung der Vorrichtung und der Beschaffenheit des ersten Trägers 30 kann somit der erste Träger 30 und / oder die Ausstoßeinrichtung 14 bewegt werden.

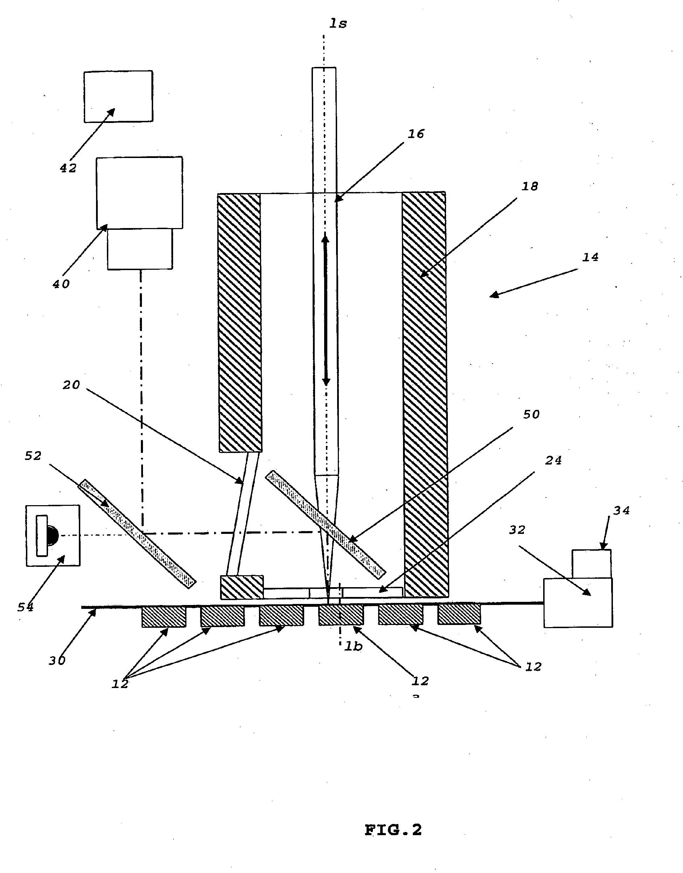

Ein zweites Ausführungsbeispiel ist in Fig. 2 dargestellt. Dieses Ausführungsbeispiel unterscheidet sich von dem in Verbindung mit Fig. 1 erläuterten Ausführungsbeispiel dadurch, dass der Strahlengang der Bilddatenerfassurigseinrichtung 40 nicht geradlinig verläuft, sondern durch einen ersten Spiegel 50 abgelenkt wird. Der erste Spiegel 50 ist im Inneren des Gehäuses 18 angeordnet. Durch die Anordnung des ersten Spiegels 50 im Inneren des Gehäuses 18 kann der Strahlengang der Bilddatenerfassungseinrichtung 40 derart abgelenkt werden, dass der Strahlengang senkrecht auf die unter dem lichtdurchlässigen Bereich 24 angeordnete Region des ersten Trägers 30 "trifft". Entsprechend weisen die von der Bilddatenerfassungseinrichtung 40 erfassten Bilddaten keine Verzerrung auf.

So kann zum Beispiel ein erster Spiegel 50 mit einer Größe von 4x6 mm mit einem Winkel von 45° zur Längsachse ls des Schiebers 16 angeordnet sein. Der erste Spiegel 50 hat eine Öffnung, die ungefähr in der Mitte des ersten Spiegels 50 angeordnet sein kann. Durch die Öffnung hindurch kann der Schieber 16 entlang seiner Längsachse ls bewegbar angeordnet sein.

Außerhalb des Gehäuses 18 ist ein zweiter Spiegel 52 vorgesehen. Der zweite Spiegel 52 kann dabei an einem separaten Trägerelement angebracht sein. Entsprechend kann die Ausstoßeinrichtung 14 unabhängig von dem zweiten Spiegel 52 bewegt werden. Das Trägerelement kann dabei dem Trägerelement entsprechen, an dem auch die Bilddatenerfassungseinrichtung 40 angebracht ist. Alternativ dazu kann der zweite Spiegel 52 auch an dem Gehäuse 18 angebracht sein.

Der zweite Spiegel 52 kann ein halbdurchlässiger Spiegel sein. Dies ermöglicht es, die von einer zweiten Strahlenquelle 54 abgegebene Strahlung in den durch die optische Achse angedeuteten Strahlengang einzukoppeln. Entsprechend ist für die zweite Strahlenquelle 54 kein separater lichtdurchlässiger Bereich erforderlich.

Die zweite Strahlenquelle 54 kann zusätzlich dazu eingerichtet sein, elektromagnetische Strahlung abzugeben, die geeignet ist, eine Klebstoffverbindung zwischen den ersten Träger 30 und den an den ersten Träger 30 vorgesehenen elektronischen Bauteilen zumindest teilweise zu lösen. Durch ein Einkoppeln der elektromagnetischen Strahlung kann somit gezielt die Region des ersten Trägers 30 bestrahlt werden, die sich unmittelbar unter dem zweiten lichtdurchlässigen Bereich 24 befindet. So kann zum Beispiel UV-Strahlung oder IR-Strahlung verwendet werden, um eine Klebeverbindung teilweise zu lösen.

Neben der Ausstoßeinrichtung 14 ist die Bilddatenerfassungseinrichtung 40 angeordnet. Dabei ist der Strahlengang zwischen dem zweiten Spiegel 52 und der Bilddatenerfassungseinrichtung 40 im Wesentlichen parallel zur Längsachse ls des Schiebers 16. Alternativ zu dem in Fig. 2 dargestellten Ausführungsbeispiel kann die Bilddatenerfassungseinrichtung 40 auch an der Position des zweiten Spiegels 52 angeordnet sein. Entsprechend ist die Bilddatenerfassungseinrichtung 40 dann nicht vertikal, so wie in Fig. 2 dargestellt, sondern horizontal angeordnet.

Durch die dargestellte Anordnung der lichtdurchlässigen Bereiche 20, 24 und der Bilddatenerfassungseinrichtung 40 können somit Bilddaten einer Region des ersten Trägers 30 erfasst werden, die bei bekannten Vorrichtungen durch die Ausstoßeinrichtung 14 verdeckt wäre. Entsprechend ermöglicht die dargestellte Anordnung, dass die elektronischen Bauteile 12 positioniert werden, wenn der erste Träger bereits an der Auflage 22 anliegt oder sich unmittelbar unter der Auflage befindet.

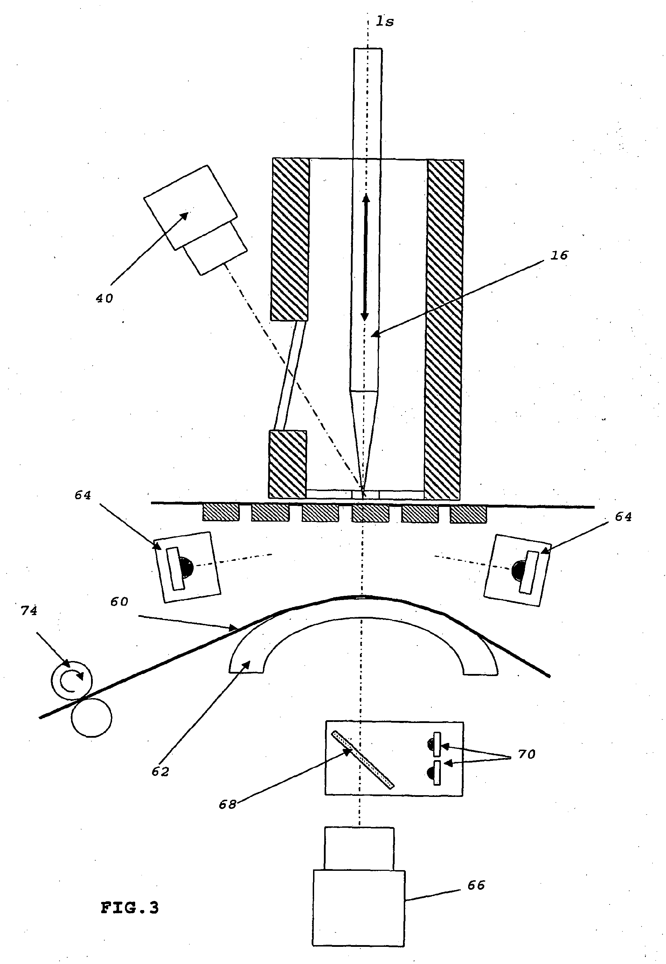

In der Fig. 3 ist eine Vorrichtung zum Übertragen von elektronischen Bauteilen von einem ersten Träger zu einem zweiten Träger dargestellt. Diese Vorrichtung umfasst neben der bereits in Verbindung mit Fig. 1 beschriebenen Vorrichtung auch eine Vorrichtung zum Positionieren des zweiten Trägers relativ zu einer Ausstoßeinrichtung.

Beabstandet von der zweiten Seite des ersten Trägers 30 ist ein zweiter Träger 60 vorgesehen. Der zweite Träger 60 kann zum Beispiel ein Substratband sein, das als Trägermaterial bei der Herstellung von Chipkarten oder Smartcards verwendet wird. Der zweite Träger 60 weist eine Kontaktfläche auf, auf der ein zu übertragendes elektronisches Bauteil 12 zu platzieren ist. Die Kontaktfläche kann dabei elektrische Kontaktierungen aufweisen, kann aber ebenso gut eine elektrisch nicht leitende Struktur sein. Neben der Kontaktfläche können noch weitere Strukturen, zum Beispiel Leiterbahnen, an dem zweiten Träger 60 vorgesehen sein. Dabei können die Leiterbahnen oder die Kontaktflächen als Markierungen verwendet werden. Ebenso ist es jedoch auch möglich, separate Markierungen vorzusehen.

Der zweite Träger 60 liegt mit seiner ersten Seite auf einer lichtdurchlässigen Auflage 62 auf. Die lichtdurchlässige Auflage 62 kann aus dem gleichen Material wie die lichtdurchlässigen Bereiche 20, 24 geformt sein und entsprechend für einen vergleichbaren Wellenlängenbereich transparent sein. Bei dem dargestellten Ausführungsbeispiel ist die lichtdurchlässige Auflage 62 gekrümmt. Die Krümmung ist dabei so gewählt, dass der zweite Träger 60 gleichmäßig an der lichtdurchlässigen Auflage 62 anliegt. Alternativ zu einer gekrümmten Auflage kann aber auch eine flache Auflage mit oder ohne abgerundeten Kanten vorgesehen sein.

Zwischen der zweite Seite des ersten Trägers 30 und der zweiten Seite des zweiten Trägers 60 ist eine dritte Strahlenquelle 64 vorgesehen. Die dritte Strahlenquelle 64 kann im Wesentlichen der ersten und zweiten Strahlenquelle 26, 54 entsprechen. Die dritte Strahlenquelle 64 ist dabei dazu eingerichtet, den Spalt zwischen dem ersten Träger 30 und dem zweiten Träger 60 zu beleuchten.

Der von der dritten Strahlenquelle 64 abgegebene Wellenlängenbereich kann auf das Material des zweiten Trägers 60 und der lichtdurchlässigen Auflage 62 abgestimmt sein. So kann die dritte Strahlenquelle 64 Strahlung in einem Wellenlängenbereich abgeben, in dem das Material des zweiten Trägers 60 und / oder der lichtdurchlässigen Auflage 62 transparent ist oder eine geringe Opazität aufweist. So kann zum Beispiel die dritte Strahlenquelle 64 Strahlung eines Wellenlängenbereichs abgeben, für den Papier eine besonders geringe Opazität aufweist.

Beabstandet von der lichtdurchlässigen Auflage 62 ist ein optisches Sensorelement 66 vorgesehen. Das optische Sensorelement 66 ist dabei auf der der Ausstoßeinrichtung 14 gegenüberliegenden Seite des lichtdurchlässigen Trägers 62 angeordnet. Das optische Sensorelement 66 ist dabei dazu eingerichtet, eine auf den zweiten Träger 60 vorgesehene Markierung zu erfassen und entsprechende Sensorsignale auszugeben. Wie bereits angedeutet kann diese Markierung eine Kontaktfläche oder eine Leiterbahn sein, die auf dem zweiten Träger 60 vorgesehen ist. Ebenso kann eine separate Markierung, zum Beispiel in Form einer Ausnehmung des zweiten Trägers 60 vorgesehen sein.

Das optische Sensorelement 66 kann zum Beispiel den vorstehend beschriebenen Bilddatenerfassungseinrichtungen 40 entsprechen. In einem besonders einfachen Ausführungsbeispiel kann das optische Sensorelement aber auch ein Fototransistor oder eine Fotodiode sein, Der Fototransistor oder die Fotodiode können dabei mit der dritten Strahlenquelle 64 eine Gabellichtschranke bilden, mit der die Ausnehmung in dem zweiten Träger 60 erfasst werden kann. Alternativ zu einer so implementierten Gabellichtschranke kann aber auch eine herkömmliche Gabellichtschranke zum Erfassen der Markierung verwendet werden.

Durch diese Anordnung der dritten Strahlenquelle 64, des zweiten Trägers 60, der lichtdurchlässigen Auflage 62 und des optischen Sensorelements 66 kann die Struktur des zweiten Trägers zum optischen Sensorelement 66 projiziert werden, also das optische Sensorelement 66 den "Schatten" des zweiten Trägers 60 erfassen.

Da die auf den zweiten Träger vorgesehenen Markierungen im Allgemeinen eine größere Opazität als das Material des zweiten Trägers 60 aufweisen, können in der Projektion die auf den zweiten Träger 60 vorgesehenen Strukturen aufgrund von Helligkeitsunterschieden gut erkannt werden und somit zur Positionierung des zweiten Träger relativ zur Ausstoßeinrichtung 14 verwendet werden.

Zwischen der lichtdurchlässigen Auflage 62 und dem optischen Sensorelement 66 ist ein teildurchlässiger Spiegel 68 vorgesehen, der dazu eingerichtet ist, die Strahlung einer vierten Strahlenquelle 70 zur lichtdurchlässigen Auflage zu reflektieren. Zudem ist der teildurchlässige Spiegel 68 dazu eingerichtet, Strahlung von der lichtdurchlässigen Auflage 62 zum optischen Sensorelement 66 durchzulassen. Je nach Ausgestaltung des teildurchlässigen Spiegels 68 kann die Anordnung der vierten Strahlenquelle 70 und des optischen Sensorelements 66 variieren. So können zum Beispiel die Positionen des optischen Sensorelements 66 und der vierten Strahlenquelle vertauscht werden.

Das optische Sensorelement 66 ist mit der Steuerung 42 verbunden. Die Steuerung 42 ist dabei dazu eingerichtet, aus den Sensorsignalen des optischen Sensorelements 66 Positionsdaten des zweiten Trägers 60 zu ermitteln. So kann zum Beispiel die Steuerung 42 die Position einer Markierung ermitteln. Aufgrund der ermittelten Positionsdaten kann die Steuerung ermitteln, ob ein Versatz zwischen der Längsachse des Schiebers ls und der Kontaktfläche für das zu übertragende elektronische Bauteil 12a vorliegt und gegebenenfalls zur Veränderung des Versatzes einen Steuerbefehl zum Ansteuern zumindest eines zweiten Aktors 74 erzeugen. Der zweite Aktor 74 ist dabei dazu eingerichtet, den zweiten Träger 60 relativ zur Ausstoßeinrichtung 14 beziehungsweise dem ersten Träger 30 zu bewegen, um dadurch den erkannten Versatz zu korrigieren. So kann zum Beispiel der zumindest eine zweite Aktor ein Antrieb sein, der das Substratband ab- beziehungsweise aufrollt.

Die von der dritten Strahlenquelle 64 abgegebene elektromagnetische Strahlung kann auch den von der Bilddatenerfassungseinrichtung 40 erfassten Teil des ersten Trägers beleuchten. Dabei kann die dritte Strahlenquelle 64 die elektronischen Bauteile 12 und Sägestraßen zwischen den elektronischen Bauteilen zur der Bilddatenerfassungseinrichtung 40 projizieren. In diesen Fall kann auf die erste und / oder zweite Strahlenquelle 26, 54 verzichtet werden.

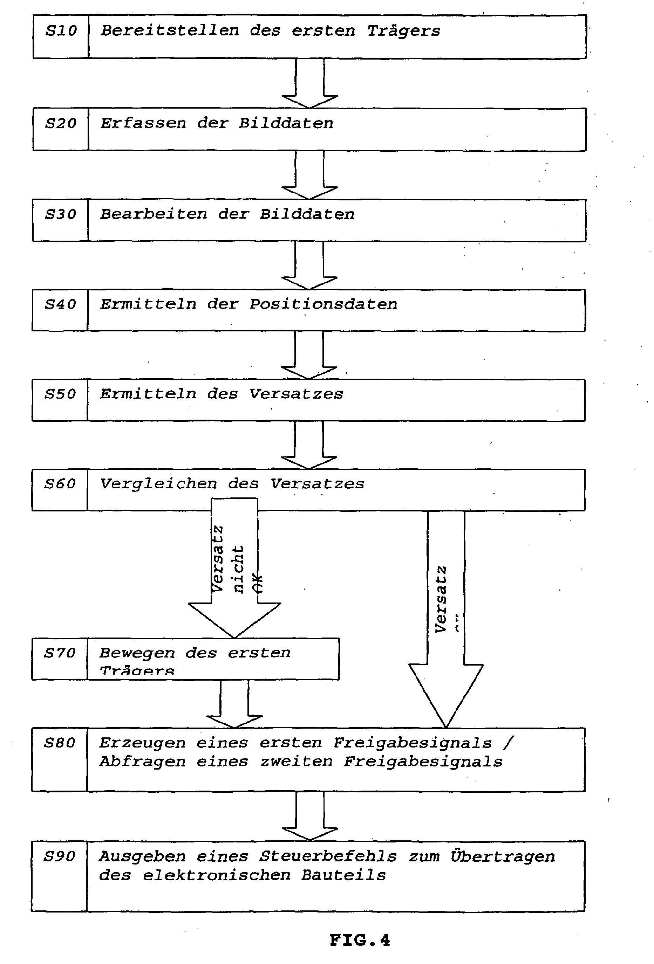

Fig. 4 zeigt ein Flussdiagramm eines Verfahrens zum Positionieren des ersten Trägers 30. In Schritt S10 wird der erste Träger 30 bereitgestellt. Dazu wird der erste Träger 30 unter der Ausstoßeinrichtung 14 angeordnet, so dass der erste Träger 30 an der Ausstoßeinrichtung 14 anliegt oder zumindest nur einen sehr geringen Abstand zur Ausstoßeinrichtung 14 aufweist. In dieser Position des ersten Trägers 30 wäre das zu übertragende elektronische Bauteil 12a durch eine herkömmliche Ausstoßeinrichtung 14 verdeckt.

In Schritt S20 erfasst die Bilddatenerfassungseinrichtung 40 Bilddaten des ersten Trägers 30. Die Bilddaten enthalten dabei zumindest Informationen zur Position des Schiebers 16 sowie zur Position des zu übertragenden elektronischen Bauteils 12a. Da die elektronischen Bauteile 12, 12a auf der von der Ausstoßeinrichtung 14 und somit auch von der Bilddatenerfassungseinrichtung 40 abgewandten zweiten Seite des ersten Trägers 30 vorgesehen sind, sollte der erste Träger 30 eine gewisse Transparenz aufweisen, so dass die Sägestraßen zwischen den elektronischen Bauteilen 12, 12a aufgrund von Helligkeitsunterschieden in den Bilddaten ermittelt werden können.

In Schritt S30 werden die Bilddaten bearbeitet, um eine perspektivische Verzerrung in den Bilddaten zu verändern. Derartige Verzerrungen treten zum Beispiel dann auf, wenn die Bilddatenerfassungseinrichtung 40, so wie in Fig. 1 dargestellt, seitlich angeordnet ist und daher die Bilddaten "schräg" erfasst, also der Strahlengang der Bilddatenerfassungseinrichtung und der erste Träger 30 einen Winkel ≠ 90° einschließen. Falls der Strahlengang der Bilddatenerfassungseinrichtung 40 und der erste Träger 30 einen Winkel = 90° einschließen, so wie zum Beispiel beim Gegenstand der Fig. 2, ist eine Bearbeitung nicht erforderlich.

In Schritt S40 werden aus den erfassten Bilddaten die Positionsdaten des zu übertragenden elektronischen Bauteils ermittelt. Zur Ermittlung der Positionsdaten können zum Beispiel die Sägestraßen verwendet werden. Sofern der erste Träger eine gewisse Transparenz aufweist, können die Sägestraßen in den erfassten Bilddaten in der Regel gut erkannt werden. Entsprechend können aus den das elektronisches Bauteil umgebenden Sägestraßen die Positionsdaten des elektronischen Bauteils ermittelt werden.

Selbst wenn die erfassten Bilddaten den Schieber 16 nicht abbilden, kann die Steuerung 42 die Position der elektronischen Bauteile 12, 12a erfassen, sofern die Bilddatenerfassungseinrichtung 40 die Bilddaten immer in der gleichen Position erfasst, also die Anordnung der Bilddatenerfassungseinrichtung 40 relativ zur Ausstoßeinrichtung 14 und zum ersten Träger 30 gleichbleibt.

In Schritt S50 wird aus den Positionsdaten ein Versatz zwischen der Längsachse ls des Schiebers und der Mittelachse des zu übertragenden elektronischen Bauteils ermittelt.

In Schritt S60 wird, sofern kein Versatz erkannt wird oder der Versatz innerhalb eines tolerierbaren Bereichs liegt, in Schritt S90 ein Steuerbefehl zum Übertagen des elektronischen Bauteils 12a erzeugt und ausgegeben. Sofern der Versatz einen Schwellenwert übersteigt, werden Steuerbefehle erzeugt und an den zumindest einen ersten Aktor 34 ausgegeben.

In Schritt S70 bewegt der zumindest eine erste Aktor 34 den ersten Träger 30 und / oder die Ausstoßeinrichtung 14, um den erkannten Versatz zu verändern.

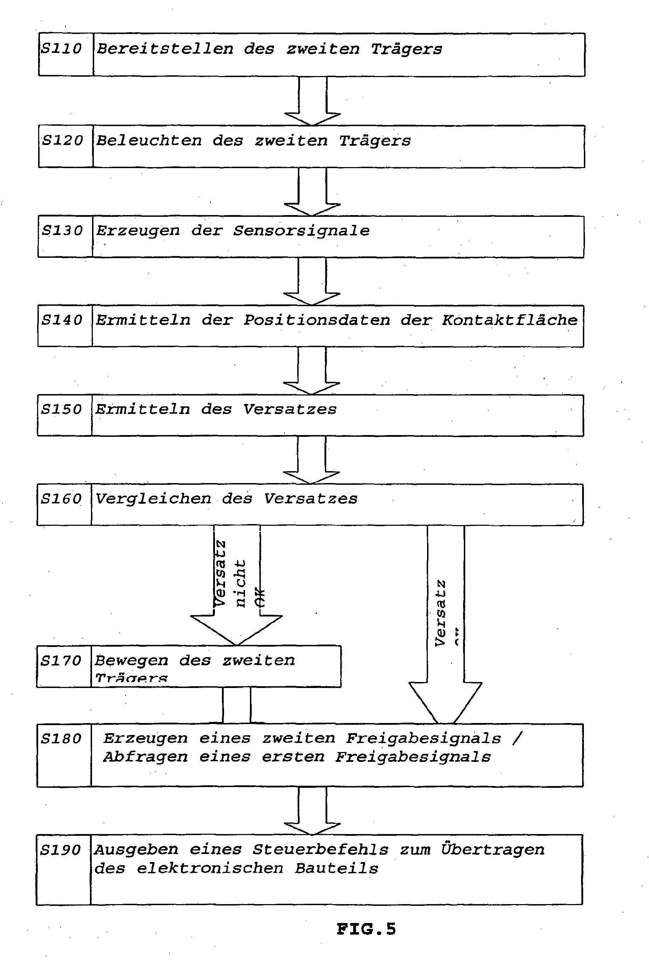

In Schritt S80 kann zum Beispiel abgefragt werden, ob der zweite Träger 60 bereits korrekt positioniert ist, also das nachstehend in Verbindung mit Fig. 5 beschriebene Verfahren bereits korrekt ausgeführt wurde. Dies kann zum Beispiel aufgrund eines in Schritt S180 erzeugten zweiten Freigabesignals erkannt werden. Entsprechend kann in Schritt S80 ein erstes Freigabesignal erzeugt werden, welches dann bei dem Verfahren zum Positionieren des zweiten Trägers 60 berücksichtigt wird.

Nachdem die Schritte S70 und S80 abgeschlossen wurden, kann in Schritt S90 ein Steuerbefehl zum Übertagen des elektronischen Bauteils 12a erzeugt und ausgegeben werden. Alternativ dazu kann auch das Verfahren erneut gestartet werden, um zu überprüfen, ob die veränderte Position des elektronischen Bauteils 12a korrekt ist.

Fig. 5 zeigt ein Flussdiagramm eines Verfahrens zum Positionieren des zweiten Trägers. In Schritt S110 wird der zweite Träger 60 bereitgestellt. Dies kann zum Beispiel durch das Abrollen eines Substratbands erfolgen. Der zweite Träger 60 weist eine Markierung auf, die von dem optischen Sensorelement 66 erfasst werden kann.

In Schritt S120 beleuchtet die dritte Strahlenquelle 64 die zweite Seite des zweiten Trägers 60. Dadurch kann ein Abbild des zweiten Trägers 60 zu dem optischen Sensorelement 66 projiziert werden. Die dritte Strahlenquelle 64 kann dabei zumindest so lange elektromagnetische Strahlung abgeben, bis das optische Sensorelement 66 entsprechende Sensorsignale ausgibt, also bis der Schritt S130 abgeschlossen ist.

In Schritt S130 erzeugt das optische Sensorelement 66 aufgrund des projizierten Abbilds des zweiten Trägers 60 Sensorsignale.

In Schritt S140 ermittelt die Steuerung 42 aus den Sensorsignalen die Positionsdaten der auf den zweiten Träger 60 vorgesehenen Kontaktfläche.

In Schritt S150 wird aus den ermittelten Positionsdaten ein Versatz zwischen der Kontaktfläche und der Längsachse des Schiebers ls ermittelt.

In Schritt S160 wird ermittelt ob der Versatz einen Schwellenwert überschreitet. Dieser Schwellenwert kann zum Beispiel vor dem Ausführen des Verfahrens festgelegt werden. Ist der Versatz kleiner als der Schwellenwert kann direkt ein Steuerbefehl zum Übertragen des elektronischen Bauteils 12a ausgegeben werden (Schritt S190). Ist der Versatz größer als der ermittelte Schwellenwert wird ein Steuerbefehl für den zumindest einen zweiten Aktor 74 erzeugt und ausgegeben.

In Schritt S170 bewegt der zumindest eine zweite Aktor 74 den zweiten Träger 60, den ersten Träger 30 und / oder die Ausstoßeinrichtung 14, um den Versatz zu verändern.

In Schritt S180 kann zum Beispiel abgefragt werden, ob der erste Träger 30 und die Ausstoßeinrichtung 14 bereits korrekt positioniert sind, also das vorstehend in Verbindung mit Fig. 4 beschriebene Verfahren bereits korrekt ausgeführt wurde. Dies kann zum Beispiel aufgrund eines in Schritt S80 erzeugten ersten Freigabesignals erkannt werden. Entsprechend kann in Schritt S180 ein zweites Freigabesignal erzeugt werden, welches bei dem Verfahren zum Positionieren des ersten Trägers 30 berücksichtigt wird.

In Schritt S190 kann dann ein Steuerbefehl zum Übertragen des elektronischen Bauteils 12a erzeugt und ausgegeben werden. Alternativ dazu kann auch das Verfahren erneut gestartet werden, um zu ermitteln, ob die Kontaktfläche zur Aufnahme des elektronischen Bauteils tatsächlich korrekt positioniert ist.

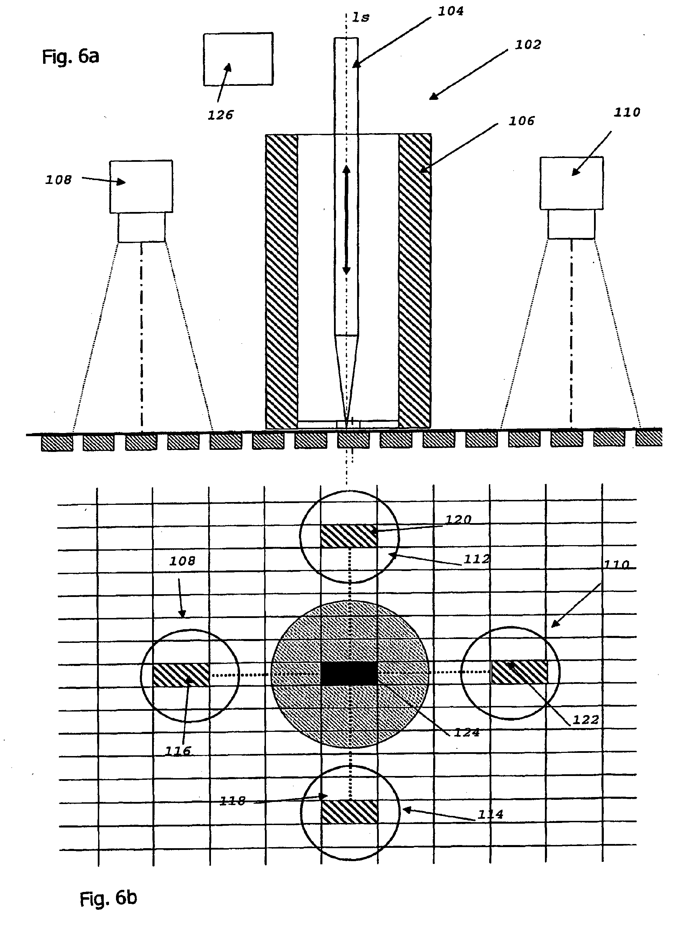

Ein weiteres Ausführungsbeispiel ist in Fig. 6a dargestellt. Eine Ausstoßeinrichtung 102 weist einen Schieber 104 und einen den Schieber 104 umgebendes Gehäuse 106 auf. Die Ausstoßeinrichtung 102 kann im Wesentlichen der in Verbindung mit Fig. 1 beschriebenen Ausstoßeinrichtung 14 entsprechen, allerdings ist bei dem in Fig. 6a dargestellten Ausführungsbeispiel kein erster lichtdurchlässiger Bereich 20 erforderlich. Das in Fig. 6a dargestellte Ausführungsbeispiel weist zumindest zwei indirekte Bilddatenerfassungseinrichtungen 108, 110 auf. Der Begriff "indirekt" deutet dabei an, dass nicht Bilddaten des zu übertragenden elektronischen Bauteils, also des Bauteils, das sich unmittelbar unter dem Schieber befindet, sondern Bilddaten von benachbarten elektronischen Bauteilen erfasst werden. Die Bedeutung von benachbart, ist dabei nicht nur auf unmittelbar angrenzende elektronische Bauteile begrenzt, sondern bezeichnet auch beabstandete elektronische Bauteile. Die indirekten Bilddatenerfassungseinrichtungen 108, 110 können der in Verbindung mit Fig. 1 beschriebenen Bilddatenerfassungseinrichtung 40 entsprechen.

Die indirekten Bilddatenerfassungseinrichtungen 108, 110 sind beabstandet von der Ausstoßeinrichtung 102 angeordnet. Die optische Achsen der indirekten Bilddatenerfassungseinrichtungen 108, 110 sind im Wesentlichen parallel zu der Längsachse ls des Schiebers 106.

Die Fig. 6b ist eine Draufsicht des in Fig. 6a dargestellten Gegenstands. Die schraffierte Fläche im Kreis deutet dabei den durch die Ausstoßeinrichtung 102 verdeckten Bereich des ersten Trägers 30 und das Gitternetz die Sägestraßen des Wafers an. Im Unterschied zu dem in Fig. 6a dargestellten Gegenstand weist der in Fig. 6b dargestellte Gegenstand vier indirekte Bilddatenerfassungseinrichtungen 108, 110, 112, 114 auf. Die indirekten Bilddatenerfassungseinrichtungen 108, 110, 112, 114 erfassen Bilddaten von elektronischen Bauteilen, die unter den indirekten Bilddatenerfassungseinrichtungen 108, 110, 112, 114 angeordnet sind. Entsprechend werden Bilddaten zu den elektronischen Bauteilen 116, 118, 120, 122 erfasst. Wie in Fig. 6b dargestellt sind die elektronischen Bauteile 116, 118, 120, 122 beabstandet von dem zu übertragenden elektronischen Bauteil 124 angeordnet.

Die von den indirekten Bilddatenerfassungseinrichtungen 108, 110, 112, 114 erfassten Bilddaten werden an eine in Fig. 6a dargestellte Steuerung 126 übertragen. Die Steuerung 126 ist dabei dazu eingerichtet, Positionsdaten der beabstandeten elektronischen Bauteile 116, 118, 120, 122 zu ermitteln. Die Steuerung 126 ist zudem dazu eingerichtet, auf gespeicherte Anordnungsdaten zuzugreifen, wobei die Anordnungsdaten Informationen zur Anordnung der elektronischen Bauteile auf den ersten Träger enthalten. Die Anordnungsdaten können zum Beispiel von einem Hersteller der elektronischen Bauteile bereitgestellt werden und in einen Speicher (nicht dargestellt) gespeichert werden. Alternativ dazu kann die Anordnung der elektronischen Bauteile auf dem ersten Träger auch vorher erfasst werden.

Anhand der ermittelten Positionsdaten und der Anordnungsdaten kann die Steuerung 126 dann Positionsdaten des zu übertragenden elektronischen Bauteils 124 ermitteln. Aufgrund der Positionsdaten des zu übertragenden elektronischen Bauteils 124 kann die Steuerung 126 ermitteln, ob die Position des zu übertragenden elektronischen Bauteils 124 einen Versatz zur Längsachse Is des Schiebers aufweist. Entsprechend kann die Steuerung 126 dann einen Steuerbefehl zum Ansteuern des zumindest einen ersten Aktors erzeugen, um durch eine daraus resultierende Bewegung des ersten Trägers 30 und / oder der Ausstoßeinrichtung den Versatz zu verändern.

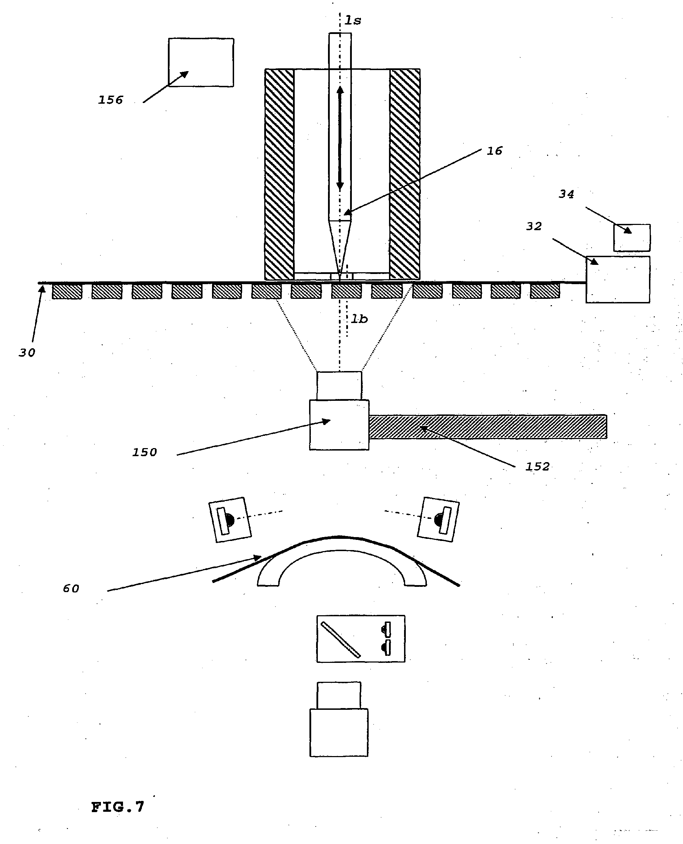

In Fig. 7 ist ein weiteres Ausführungsbeispiel dargestellt. Bei diesem Ausführungsbeispiel ist zusätzlich oder alternativ zu den vorstehend beschriebenen Bilddatenerfassungseinrichtungen 40, und indirekten Bilddatenerfassungseinrichtungen 108, 110, 112, 114 eine bewegliche Bilddatenerfassungseinrichtung 150 vorgesehen. Die bewegliche Bilddatenerfassungseinrichtung 150 ist dabei zum Beispiel an einen Schwenkarm 152 angebracht, der es ermöglicht, die bewegliche Bilddatenerfassungseinrichtung 150 zwischen der in Fig. 7 dargestellten ersten Position und einer zweiten Position (nicht dargestellt) zu bewegen.

Die erste Position befindet sich dabei zwischen dem ersten Träger 30 und dem zweiten Träger 60, auf den die elektronischen Bauteile 12 übertragen werden sollen. Entsprechend kann die bewegliche Bilddatenerfassungseinrichtung 150 Bilddaten der zweiten Seite des ersten Trägers 30 erfassen. Die erste Position kann zum Beispiel so gewählt sein, dass die optische Achse der beweglichen Bilddatenerfassungseinrichtung 150 mit der Längsachse ls des Schiebers übereinstimmt. Die bewegliche Bilddatenerfassungseinrichtung 150 kann die erfassten Bilddaten an eine Steuerung 156 übertragen. Die Steuerung 156 kann dann aus den erfassten Bilddaten Positionsdaten eines zu übertragenden elektronischen Bauteils ermitteln. Vergleichbar zu den vorstehend beschriebenen Ausführungsbeispielen kann die Steuerung 156 aus den Positionsdaten ermitteln, ob ein Versatz zwischen der Längsachse ls des Schiebers 16 und der Mittelachse lb des elektronischen Bauteils 12 vorliegt. Falls dieser Versatz einen Schwellenwert überschreitet, wird ein Steuerbefehl erzeugt, mit dem dann der zumindest eine erste Aktor 34 angesteuert wird, um den Versatz zu verändern.

Die bewegliche Bilddatenerfassungseinrichtung 150 ermöglicht es, verzerrungsfreie Bilddaten der elektronischen Bauteile 12 zu erfassen. Da sich die bewegliche Bilddatenerfassungseinrichtung 150 allerdings zwischen dem ersten Träger 30 und dem zweite Träger 60 befindet, muss die bewegliche Bilddatenerfassungseinrichtung 150 bevor elektronische Bauteile übertragen werden können, in die zweite Position bewegt werden. Zudem kann es erforderlich sein, den Abstand zwischen dem ersten Träger 30 und dem zweiten Träger 60 zu vergrößern. Dazu kann eine Bewegung des ersten Trägers 30, der Ausstoßeinrichtung 14 und / oder eine Bewegung des zweiten Trägers 60 vorgesehen sein.

Falls die Anordnung der elektronischen Bauteile auf den ersten Träger bekannt ist, also die Anordnung der elektronischen Bauteile auf den ersten Träger 30 bereits erfasst wurde oder von dem Hersteller der elektronischen Bauteile bereitgestellt wurde und in Form von Anordnungsdaten vorliegt, können, um das Übertragen der elektronischen Bauteile zu beschleunigen, die Positionsdaten der elektronischen Bauteile 12 auch stichprobenartig erfasst werden. So kann zum Beispiel die bewegliche Bilddatenerfassungseinrichtung 150, nachdem eine bestimmte Anzahl von elektronischen Bauteilen von dem ersten Träger auf den zweiten Träger übertragen worden ist, in die erste Position gebracht werden, um die Positionsdaten eines elektronischen Bauteils zu ermitteln. Aufgrund der ermittelten Positionsdaten kann dann ein etwaiger Versatz korrigiert werden. Zudem kann aus den gespeicherten Anordnungsdaten die Position der benachbarten elektronischen Bauteile extrapoliert werden. So ist es zum Beispiel möglich, für jede Spalte bzw. Reihe elektronischer Bauteile jeweils nur die Positionsdaten eines elektronischen Bauteils zu erfassen. Dies kann zum Beispiel das elektronische Bauteil sein, das als erstes Bauteil der Spalte oder der Reihe übertragen werden soll. Die Position der restlichen elektronischen Bauteile der Spalte oder der Reihe wird dann durch Extrapolieren ermittelt. Es ist ersichtlich, dass eine stichprobenartige Überprüfung auch in Verbindung mit den in Fig. 4 und 5 dargestellten Verfahren vorgesehen sein kann.

Ebenso kann mit der beweglichen Bilddatenerfassungseinrichtung 150 die Position eines oder mehrerer Referenz-Bauteile ermittelt werden. Das oder die Referenz-Bauteile können zum Beispiel Referenzdies der Wafermap sein, also Bauteile deren Position als Bezugspunkte für die Anordnungsdaten dienen.

Die in Fig. 7 dargestellte bewegliche Bilddatenerfassungseinrichtung 150 kann zum Beispiel auch dazu verwendet werden, Anordnungsdaten der auf den ersten Träger vorgesehenen elektronischen Bauteile zu erfassen.

Die in den Figuren ersichtlichen Proportionen und Abmessungen sind gewählt, um wesentliche Eigenschaften und Merkmale der Vorrichtung / des Verfahrens zu verdeutlichen; bei einer realisierten Vorrichtung können diese Proportionen und Abmessungen anders gewählt sein.

## Patentansprüche

1. Vorrichtung zum Positionieren zu übertragender elektronischer Bauteile (12, 12a) relativ zu einer Ausstoßeinrichtung (14), mit:
- der Ausstoßeinrichtung (14), die einen Schieber (16) für zumindest ein elektronisches Bauteil (12, 12a) und ein den Schieber (16) umgebendes Gehäuse (18) aufweist, wobei das Gehäuse (18) eine langgestreckte Form hat und an einer Längsseite einen ersten lichtdurchlässigen Bereich (20) aufweist;
- einem die zu übertragenden elektronischen Bauteile (12, 12a) bereitstellenden ersten Träger (30), der eine der Ausstoßeinrichtung (14) zugewandte erste Seite und eine von der Ausstoßeinrichtung (14) abgewandte zweite Seite umfasst, wobei auf der zweiten Seite eine Vielzahl der elektronischen Bauteile (12, 12a) vorgesehen ist;
- zumindest einer seitlich neben dem Gehäuse angeordneten Bilddatenerfassungseinrichtung (40), die dazu eingerichtet ist, durch den ersten lichtdurchlässigen Bereich (20) des Gehäuses (18) hindurch Bilddaten einer Region zu erfassen, in der der Schieber (16) mit dem wenigstens einen elektronischen Bauteil (12a) zu interagieren eingerichtet ist;
- einer Steuerung (42), die dazu eingerichtet ist, aus den erfassten Bilddaten Positionsdaten des zu übertragenden elektronischen Bauteils (12a) zu ermitteln sowie aufgrund der Positionsdaten Steuerbefehle zu erzeugen; - zumindest einem Aktor (34), der dazu eingerichtet ist, den ersten Träger (30) und die Ausstoßeinrichtung (14) aufgrund der Steuerbefehle relativ zueinander zu positionieren, um einen Versatz zwischen einer Längsachse (Is) des Schiebers und einer Mittelachse (lb) des zu übertragenden elektronischen Bauteils (12a) zu verändern;
- einem zweiten Träger (60) mit zumindest einer Kontaktfläche zur Aufnahme des zu übertragenen elektronischen Bauteils (12a);
- ein optisches Sensorelement (66), das dazu eingerichtet ist, eine auf dem zweiten Träger (60) vorgesehene Markierung zu erfassen und Sensorsignale zu erzeugen, wobei die Sensorsignale Informationen zur Position der Markierung und der Position der Ausstoßeinrichtung umfassen;
- wobei die Steuerung (42) dazu eingerichtet ist, Positionsdaten der Kontaktfläche aufgrund der erzeugten Sensorsignale zu ermitteln und Steuerbefehle zum Ansteuern zumindest eines zweiten Aktors (74) aufgrund der ermittelten Positionsdaten der Kontaktfläche zu erzeugen, um den zweiten Träger (60) relativ zu dem ersten Träger (30) und der Ausstoßeinrichtung (14) aufgrund der erzeugten Steuerbefehle in Richtungen senkrecht zur Längsachse (Is) des Schiebers (16) zu positionieren, um einen Versatz zwischen der Kontaktfläche und einer Längsachse (Is) eines Schiebers der Ausstoßeinrichtung (14) zu verändern.

2. Vorrichtung nach Anspruch 1, wobei die Ausstoßeinrichtung (14) einen im Inneren des Gehäuses (18) angeordneten ersten Spiegel (50) umfasst.

3. Vorrichtung nach Anspruch 1, wobei eine erste Strahlenquelle (26) im Inneren des Gehäuses (18) vorgesehen ist, oder
wobei eine erste Strahlenquelle (26) außerhalb des Gehäuses (18) vorgesehen ist.

4. Vorrichtung nach Anspruch 2 wobei der erste Spiegel (50) eine Öffnung aufweist, durch die der Schieber (16), in Richtung seiner Längsachse (Is), beweglich angeordnet ist.

5. Vorrichtung nach einem der Ansprüche 1 bis 4, wobei außerhalb des Gehäuses (18) ein zweiter Spiegel (52) vorgesehen ist.

6. Vorrichtung nach Anspruch 5, wobei der zweite Spiegel (52) ein halbdurchlässiger Spiegel ist, der dazu eingerichtet ist, elektromagnetische Strahlung einer zweiten Strahlenquelle (54) einzukoppeln.

7. Vorrichtung nach Anspruch 6, wobei die zweite Strahlenquelle (54) dazu eingerichtet ist, elektromagnetische Strahlung abzugeben, die geeignet ist, das elektronische Bauteil (12, 12a) von dem ersten Träger (30) zumindest teilweise zu lösen.

8. Vorrichtung nach einem der Ansprüche 1 bis 7, wobei das Gehäuse (18) einen zweiten lichtdurchlässigen Bereich (24) aufweist, und wobei der zweite lichtdurchlässige Bereich (24) eine Öffnung aufweist, durch die der Schieber (16), in Richtung seiner Längsachse (Is) beweglich angeordnet ist.

9. Vorrichtung nach Anspruch 1 zum Positionieren eines zweiten Trägers (60) mit einer Kontaktfläche zur Aufnahme eines elektronischen Bauteils relativ zu einer Ausstoßeinrichtung (14), mit
- einer lichtdurchlässigen Auflage (62), auf der eine erste Seite des zweiten Trägers (60) aufliegt;
- zumindest einer dritten Strahlenquelle (64), die beabstandet von dem zweiten Träger (60) auf einer von der lichtdurchlässigen Auflage (62) abgewandten zweiten Seite des zweiten Trägers (60) angeordnet ist;
- zumindest einem optischen Sensorelement (66), das dazu eingerichtet ist, eine auf den zweiten Träger (60) aufgebrachte Markierung zu erfassen und entsprechende Sensorsignale zu erzeugen;
- einer Steuerung (42), die dazu eingerichtet ist, aus den Sensorsignalen Positionsdaten der Kontaktfläche zu ermitteln und aufgrund der Positionsdaten Steuerbefehle zu erzeugen; und
- zumindest einem zweiten Aktor (74), der dazu eingerichtet ist, einen ersten Träger (30), die Ausstoßeinrichtung (14) und / oder den zweiten Träger (60) aufgrund der Steuerbefehle zu bewegen, um einen Versatz zwischen einer Längsachse der Ausstoßeinrichtung und der Kontaktfläche zu verändern.

10. Vorrichtung nach Anspruch 9, wobei zwischen dem zumindest einem optischen Sensorelement (66) und der lichtdurchlässigen Auflage (62) ein Spiegelelement (68) angeordnet ist, das dazu eingerichtet ist, eine von einer vierten Strahlenquelle (70) abgegebene elektromagnetische Strahlung in den Strahlengang zwischen dem optischen Sensorelement (66) und der lichtdurchlässigen Auflage (62) einzukoppeln.

11. Vorrichtung nach Anspruch 9 oder 10, wobei die Markierung die Kontaktfläche für das zu übertragende elektronische Bauteil und / oder eine auf dem zweiten Träger (60) vorgesehene Leiterstruktur ist.

12. Vorrichtung nach Anspruch 9, wobei die dritte Strahlenquelle (64) dazu eingerichtet ist, die zweite Seite des ersten Trägers (30) und die zweite Seite des zweiten Trägers (60) zu beleuchten.

13. Verfahren zum Positionieren eines zu übertragenden elektronischen Bauteils relativ zu einer Ausstoßeinrichtung mit einem in einem Gehäuse (18) angeordneten Schieber (16), wobei das Gehäuse (18) eine langgestreckte Form hat und an einer Längsseite einen ersten lichtdurchlässigen Bereich (20) aufweist, mit den Schritten:
- Bereitstellen eines ersten Trägers (30) mit elektronischen Bauteilen (12, 12a), so dass eine erste Seite des ersten Trägers (30) an der Ausstoßeinrichtung (14) anliegt, und wobei eine Vielzahl von elektronischen Bauteilen (12, 12a) an einer von der Ausstoßeinrichtung (14) abgewandten zweiten Seite des ersten Trägers (30) vorgesehen ist;
- Erfassen von Bilddaten mittels einer seitlich neben dem Gehäuse angeordneten Bilderfassungseinrichtung (40) durch den ersten lichtdurchlässigen Bereich (20), wobei die Bilddaten Informationen zur Position eines Schiebers (16) der Ausstoßeinrichtung und zur Position eines zu übertragenden elektronischen Bauteils (12a) umfassen;
- Ermitteln von Positionsdaten des zu übertragenden elektronischen Bauteils (12a) aufgrund der erfassten Bilddaten;
- Erzeugen eines Steuerbefehls zum Ansteuern zumindest eines ersten Aktors (34) aufgrund der ermittelten Positionsdaten des zu übertragenden elektronischen Bauteils (12a);
- Bereitstellen eines zweiten Trägers (60) mit zumindest einer Kontaktfläche zur Aufnahme eines zu übertragenen elektronischen Bauteils (12a), so dass ein optisches Sensorelement (66) eine auf dem zweiten Träger (60) vorgesehene Markierung erfassen kann;
- Projizieren eines Abbilds des zweiten Trägers (60) zu dem optischen Sensorelement (66);
- Erzeugen von Sensorsignalen, wobei die Sensorsignale Informationen zur Position der Markierung und der Position der Ausstoßeinrichtung umfassen;
- Ermitteln der Positionsdaten der Kontaktfläche aufgrund der erzeugten Sensorsignale;
- Erzeugen von Steuerbefehlen zum Ansteuern zumindest eines zweiten Aktors (74) aufgrund der ermittelten Positionsdaten der Kontaktfläche; und
- Positionieren des zweiten Trägers (60), des ersten Trägers (30) und der Ausstoßeinrichtung (14) aufgrund der erzeugten Steuerbefehle in Richtungen senkrecht zur Längsachse (Is) des Schiebers (16), um einen Versatz zwischen der Kontaktfläche und einer Längsachse (Is) eines Schiebers der Ausstoßeinrichtung (14) zu verändern.

14. Verfahren nach Anspruch 13, bei dem innerhalb des Gehäuses (18) ein Unterdruck beim Übertragen der elektronischen Bauteile und / oder dem Lösen der elektronischen Bauteile von dem ersten Träger (30) aufgebaut wird.

## Claims

1. An apparatus for positioning electronic components (12, 12a) to be transferred relative to a discharging device (14), comprising:
- the discharging device (14) including a slide (16) for at least one electronic component (12, 12a) and a housing (18) encasing the slide (16), wherein the housing (18) has an obling shape and along its long side has a first translucent region (20);
- a first carrier (30) providing the electronic components (12, 12a) to be transferred, said carrier comprising a first side facing the discharging device (14) and a second side facing away from the discharging device (14), wherein a plurality of electronic components (12, 12a) is provided on the second side;
- at least one image data capturing device (40) arranged to the side of the housing, which is adapted to capture image data of a region through the first translucent region (20) of the housing (18), in which the slide (16) is configured to interact with the at least one electronic component (12a);
- a control (42) configured to determine positional data of the electronic component (12a) to be transferred from the captured image data as well as to generate control commands on the basis of the positional data;
- at least one actuator (34) configured to position the first carrier (30) and the discharging device (14) relative to each other on the basis of the positional data in order to change an offset between a longitudinal axis (Is) of the slide and a central axis (Ib) of the electronic component (12a) to be transferred;
- a second carrier (60) comprising at least one contact surface for receiving the electronic component (12a) to be transferred:
- an optical sensor element (66) configured to detect a mark provided on the second carrier (60) and to generate sensor signals, wherein the sensor signals include information about the position the mark and the position of the discharging device;
- wherein the discharging device (42) is configured to determine the positional data of the contact surface on the basis of the generated sensor signal and to generate control commands for driving at least a second actuator (74) on the basis of the determined positional data of the contact surface, in order to position the second carrier (60) relative to the first carrier (30) and the discharging device (14) on the basis of the generated control commands in directions vertically to the longitudinal axis (ls) of the slide (16) in order to change an offset between the contact surface and an longitudinal axis (Is) of a slide of the discharging device (14).

2. The apparatus according to claim 1, wherein the discharging device (14) comprises a first mirror (50) arranged inside the housing (18).

3. The apparatus according to claim 1, wherein a first source of radiation (26) is provided inside the housing (18) or wherein a first source of radiation (26) is provided outside the housing (18).

4. The apparatus according to claim 2, wherein the first mirror (50) has an aperture, through which the slide (16) is arranged movably in its longitudinal axis (Is).

5. The apparatus according to any one of claims 1 to 4, wherein outside the housing (18) a second mirror (52) is provided.

6. The apparatus according to claim 5, wherein the second mirror (52) is a semipermeable mirror, which is configured to couple electromagnetic radiation from a second source of radiation (54).

7. The apparatus according to claim 6, wherein the second source of radiation (54) is adapted to emit electromagnetic radiation which is adapted to at least partially break the electronic component (12, 12a) from the first carrier (30).

8. The apparatus according to any one of claims 1 to 7, wherein the housing (18) comprises a second translucent region (24) and wherein the second translucent region (24) includes an aperture through which is slide (16) is arranged movably in the direction of its longitudinal axis (ls).

9. The apparatus according to claim 1 for positioning a second carrier (60) with a contact surface for receiving an electronic component in relation to a discharging device (14), comprising
- a translucent support (62), on which a first side of the second carrier (60) rests;
- at least a third source of radiation (64) which at a distance from the second carrier (60) is arranged on a second side of the second carrier (60) facing away from the translucent support (62);
- at least one optical sensor element (66), which is configured to detect a mark that is provided on the second carrier (60) and to generate corresponding sensor signals;
- a control (42), which is configured to determine positional data of the contact surface from the sensor signals and to generate control commands on the basis of the positional data; and
- at least a second actuator (74), which is adapted to move a first carrier (30), the discharging device (14) and/or the second carrier (60) on the basis of the control commands, in order to change an offset between the longitudinal axis of the discharging device and the contact surface.

10. The apparatus according to claim 9, wherein between the at least one optical sensor element (66) and the translucent support (62) a mirror element (68) is arranged, which is configured to couple an electromagnetic radiation that is emitted from a fourth source of radiation (70) into the light path between the optical sensor element (66) and the translucent support (62).

11. The apparatus according to claim 9 or claim 10, wherein the mark is the contact surface for the electronic component to be transferred and/or a conducting structure provided on the second carrier (60).

12. The apparatus according to claim 9, wherein the third source of radiation (64) is configured to illuminate the second side of the first carrier (30) and the second side of the second carrier (60).

13. A method for positioning an electronic component to be transferred relative to the discharging device including a slide (16) arranged in a housing (18), wherein the housing (18) comprises an oblong shape and along a long side has a first translucent region (20), including the steps:
- providing a first carrier (30) with electronic components (12, 12a) so that a first side of the first carrier (30) rests against the discharging device (14) and a plurality of electronic components (12, 12a) is provided on a second side of the first carrier (30) that is facing away from the discharging device (14);
- capturing image data by means of an image data capturing device (40) that is arranged next to the side of the housing through the first translucent region (20), wherein the image data include information about the position of a slide (16) of the discharging device and the position of an electronic component (12a) to be transferred;
- determining positional data of the electronic component (12a) to be transferred on the basis of the captured image data;
- generating a control command for driving at least a first actuator (34) on the basis of the determined positional data of the electronic component (12a) to be transferred;
- providing a second carrier (60) including at least one contact surface for receiving an electronic component (12a) to be transferred so that an optical sensor element (66) can detect a mark that is provided on the second carrier (60);
- projecting an image of the second carrier (60) to an optical sensor element (66);
- generating sensor signals, wherein the sensor signals include information about the position of the mark and the position of the discharging device;
- determining the positional data of the contact surface on the basis of the generated sensor signals;
- generating control commands for driving at least a second actuator (74) on the basis of the determined positional data of the contact surface; and positioning the second carrier (60), the first carrier (30) and the discharging device (14) in directions vertically to the longitudinal axis (is) of the slide (16) on the basis of the generated control commands, in order to change an offset between the contact surface and a longitudinal axis (Is) of a slide of the discharging device (14).

14. The method according to claim 13, wherein inside the housing (18) a low pressure is built up on transferring the electronic components and/or on breaking the electronic components from the first carrier (30).

## Revendications

1. Dispositif permettant de positionner des composants électroniques (12, 12a) à transférer par rapport à un dispositif d'éjection (14), comprenant :
- ledit dispositif d'éjection (14) présentant un coulisseau (16) pour au moins un composant électronique (12, 12a), et un boîtier (18) entourant ledit coulisseau (16), ledit boîtier (18) possédant une forme allongée et présentant sur un côté longitudinal une première zone transparente (20) ;
- un premier support (30) qui fournit les composants électroniques (12, 12a) à transférer et comporte une première face tournée vers le dispositif d'éjection (14) et une deuxième face opposée au dispositif d'éjection (14), une pluralité de composants électroniques (12, 12a) étant prévue sur la deuxième face ;
- au moins un dispositif de détection de données d'image (40) qui est disposé latéralement à côté du boîtier et conçu pour détecter à travers ladite première zone transparente (20) du boîtier (18) des données d'image d'une région dans laquelle le coulisseau (16) est conçu pour interagir avec ledit au moins un composant électronique (12a) ;
- une commande (42) qui est conçue pour déterminer, à partir des données d'image détectées, des données de position du composant électronique (12a) à transférer et pour produire des instructions de commande à partir desdites données de position ;
- au moins un actionneur (34) qui est conçu pour positionner, à partir des instructions de commande ledit premier support (30) et le dispositif d'éjection (14) l'un par rapport à l'autre afin de modifier un décalage entre un axe longitudinal (Is) du coulisseau et un axe médian (Ib) du composant électronique (12a) à transférer :
- un deuxième support (60) pourvu d'au moins une surface de contact pour la réception du composant électronique (12a) à transférer :
- un détecteur optique (66) qui est conçu pour détecter une marque prévue sur ledit deuxième support (60) et pour produire des signaux de détection, ces signaux contenant des informations sur la position de cette marque et sur la position du dispositif d'éjection ;
- ladite commande (42) étant conçue pour déterminer, à partir des signaux de détection produits, des données de position de la surface de contact et pour produire des instructions de commande pour commander au moins un deuxième actionneur (74) à partir des données de position déterminées pour la surface de contact afin de positionner, dans des directions perpendiculaires à l'axe longitudinal (Is) du coulisseau (16), le deuxième support (60) par rapport au premier support (30) et au dispositif d'éjection (14) afin de modifier un décalage entre la surface de contact et un axe longitudinal (Is) d'un coulisseau du dispositif d'éjection (14).

2. Dispositif selon la revendication 1, le dispositif d'éjection (14) comportant un premier miroir (50) disposé à l'intérieur du boîtier (18).

3. Dispositif selon la revendication 1, une première source de rayonnement (26) étant prévue à l'intérieur du boîtier (18), ou
une première source de rayonnement (26) étant prévue à l'extérieur du boîtier (18).

4. Dispositif selon la revendication 2, ledit premier miroir (50) présentant une ouverture à travers laquelle le coulisseau (16) est disposé de façon mobile en direction de son axe longitudinal (ls).

5. Dispositif selon l'une des revendications 1 à 4, un deuxième miroir (52) étant prévu à l'extérieur du boîtier (18).

6. Dispositif selon la revendication 5, ledit deuxième miroir (52) étant un miroir semi-transparent qui est conçu pour être couplé au rayonnement électromagnétique d'une deuxième source de rayonnement (54).

7. Dispositif selon la revendication 6, ladite deuxième source de rayonnement (54) étant conçue pour émettre un rayonnement électromagnétique apte à faire se détacher le composant électronique (12, 12a) au moins partiellement du premier support (30).

8. Dispositif selon l'une des revendications 1 à 7, le boîtier (18) présentant une deuxième zone transparente (24), et cette deuxième zone transparente (24) présentant une ouverture à travers laquelle le coulisseau (16) est disposé de façon mobile en direction de son axe longitudinal (Is).

9. Dispositif selon la revendication 1 permettant de positionner un deuxième support (60) pourvu d'une surface de contact pour la réception d'un composant électronique, par rapport à un dispositif d'éjection (14), comprenant
- un appui transparent (62) sur lequel repose une première face du deuxième support (60) ;
- au moins une troisième source de rayonnement (64) qui est disposée à distance du deuxième support (60) sur une deuxième face du deuxième support (60) opposée audit appui transparent (62) ;
- au moins un détecteur optique (66) qui est conçu pour détecter une marque appliquée sur le deuxième support (60) et pour produire des signaux de détection correspondants ;
une commande (42) qui est conçue pour déterminer des données de position de la surface de contact à partir des signaux de détection et pour produire des instructions de commande à partir des données de position ; et
- au moins un deuxième actionneur (74) qui est conçu pour déplacer un premier support (30), le dispositif d'éjection (14) et/ou le deuxième support (60) à partir des instructions de commande afin de modifier un décalage entre un axe longitudinal (Is) du dispositif d'éjection et la surface de contact.

10. Dispositif selon la revendication 9, un élément formant miroir (68) étant disposé entre ledit au moins un détecteur optique (66) et l'appui transparent (62), lequel élément est conçu pour être couplé à un rayonnement électromagnétique émis par une quatrième source de rayonnement (70) dans la trajectoire du faisceau, entre le détecteur optique (66) et l'appui transparent (62).

11. Dispositif selon la revendication 9 ou 10, la marque étant la surface de contact pour le composant électronique à transférer et/ou une structure conductrice prévue sur le deuxième support (60).

12. Dispositif selon la revendication 9, la troisième source de rayonnement (64) étant conçue pour éclairer la deuxième face du premier support (30) et la deuxième face du deuxième support (60).

13. Procédé permettant de positionner un composant électronique à transférer par rapport à un dispositif d'éjection comprenant un coulisseau (16) disposé dans un boîtier (18), ce boîtier (18) possédant une forme allongée et présentant sur un côté longitudinal une première zone transparente (20), comportant les étapes suivantes :
- la mise à disposition d'un premier support (30) comportant des composants électroniques (12, 12a) de sorte qu'une première face du premier support (30) se trouve placée contre le dispositif d'éjection (14), une pluralité de composants électroniques (12, 12a) étant prévue sur une deuxième face du premier support (30) opposée au dispositif d'éjection (14) ;
- la détection de données d'image à travers la première zone transparente (20) au moyen d'un dispositif de détection d'images (40) disposé latéralement à côté du boîtier, ces données d'images contenant des informations sur la position d'un coulisseau (16) du dispositif d'éjection et sur la position d'un composant électronique (12a) à transférer ;
- la détermination de données de position du composant électronique (12a) à transférer à partir des données d'images détectées ;
- la production d'une instruction de commande pour commander au moins un premier actionneur (34) à partir des données de position déterminées pour le composant électronique (12a) à transférer ;
- la mise à disposition d'un deuxième support (30) pourvu d'au moins une surface de contact pour la réception d'un composant électronique (12a) à transférer de sorte qu'un détecteur optique (66) peut détecter une marque prévue sur le deuxième support (60) ;
- la projection d'une image du deuxième support (60) vers le détecteur optique (66) ;
- la production de signaux de détection, ces signaux contenant des informations sur la position de la marque et sur la position du dispositif d'éjection ;
- la détermination des données de position de la surface de contact à partir des signaux de détection produits ;
- la production d'instructions de commande pour commander au moins un deuxième actionneur (74) à partir des données de position déterminées pour la surface de contact ; et
- le positionnement du deuxième support (60), du premier support (30) et du dispositif d'éjection (14) à partir des instructions de commande produites, dans des directions perpendiculaires à l'axe longitudinal (Is) du coulisseau (16) afin de modifier un décalage entre la surface de contact et un axe longitudinal (Is) d'un coulisseau du dispositif d'éjection (14).

14. Procédé selon la revendication 13, dans le cadre duquel une dépression est créée à l'intérieur du boîtier (18) lors du transfert des composants électroniques et/ou du détachement des composants électroniques du premier support (30).
